# EUROPÄISCHE PATENTSCHRIFT

(11) **EP 2 544 012 B1**
(45) Veröffentlichungstag und Bekanntmachung des Hinweises auf die Patenterteilung: **04.05.2016**
(21) Anmeldenummer: 12187511.6
(22) Anmeldetag: 25.03.2004
(51) Int. Cl.: G01R 22/06

(54) **Anordnung aus Stromzähler und Anschlussvorrichtung für den Stromzähler**
System of electricity meter and connecting device for said electricity meter
Système d' un compteur d'électricité et d'un dispositif de connexion pour ledit compteur d'électricité

(30) Priorität: 27.03.2003 DE 10313999; 16.05.2003 DE 10323161
(43) Veröffentlichungstag der Anmeldung: 09.01.2013
(62) Teilanmeldung aus: 04007202.7
(73) Patentinhaber: Hager Electro GmbH & Co. KG, 66440 Blieskastel (DE)
(72) Erfinder: Kelaiditis, Dr.-Ing. Konstantin, 66386 St. Ingbert (DE); Clemens, Dr.-Ing. Guntram, 31787 Hameln (DE); Zimmermann, Michael, 66399 Mandelbachtal (DE); Zimmermann, Manfred, 66131 Saarbrücken (DE)
(74) Vertreter: Nuss, Laurent

(56) Entgegenhaltungen:
- DE-A- 10 052 998
- DE-A- 10 054 771
- DE-C- 669 192
- DE-U1- 20 216 393
- US-A- 3 369 088
- US-A- 4 388 670
- US-A- 6 059 605
- WISY M ET AL: "eHZ VDN - Lastenheft Elektronische Haushaltszaehler Version 0.3", EHZ VDN - LASTENHEFT ELEKTRONISCHE HAUSHALTSZAEHLER VERSION 0.3, VDN, DE, Bd. Version 0.3, 16. Februar 2003 (2003-02-16), Seiten 1-23, XP008158049,
- WISY M: "VDN-Lastenheft Elektronische Haushaltszaehle", VDN-LASTENHEFT ELEKTRONISCHE HAUSHALTSZAEHLER, VDN, DE, Bd. Version 0.4, 6. April 2003 (2003-04-06), XP008158182,
- WISY M: "VDN - LASTENHEFT ELEKTRONISCHE HAUSHALTSZAEHLER, PASSAGE", VDN - LASTENHEFT ELEKTRONISCHE HAUSHALTSZAEHLER, XX, XX, Bd. .5, 10. April 2003 (2003-04-10), Seiten 1-22, XP008062908,

## Beschreibung

Die Erfindung betrifft eine Anordnung aus einem Stromzähler und einer Anschlussvorrichtung für den Stromzähler, der ein Gehäuse aufweist, von dessen gegen eine Tragplatte anlegbarem Boden durch Öffnungen in der Tragplatte hindurchführbare Kontaktelemente entsprechend wenigstens einer Stromphase vorstehen, welche durch Verschiebung des auf der Tragplatte geführten Gehäuses mit Strom zu- und abführenden Anschlusselementen auf der dem Stromzähler abgewandten Seite der Tragplatte verbindbar sind, wobei die Anschlusselemente an den Kontaktelementen zangenartig mit durch die Verschiebebewegung der Kontaktelemente aufspreizbaren, federkraftbeaufschlagten Zangenbacken angreifen.

Aus XP008158049, VDN-Lastenheft Elektronische Haushattszähler, Version 0.3 vom 16.2.2003 ist ein elektronischer Stromzähler mit einem quaderförmigen Gehäuse bekannt, von dessen Rückseite plattenförmige Kontaktelemente vorstehen. Weitere elektronische Stromzählers mit Kontaktelementen auf einer Rückseite gehen aus der DE 20216393 U1, der DE 10054771 A1 sowie der US 6059605 hervor, wobei letzteres Dokument einen auf einen Stecksockel aufsteckbaren Stromzählers beschreibt Eine weitere Sockelbaugruppe zum Anschluss von einem Stromzähler vorstehender Kontaktelemente ist aus der US 4388670 bekannt

Eine Anordnung der eingangs genannten Art mit einer Anschlussvorrichtung geht aus der DE 100 52 998 A1 sowie der deutschen Patentanmeldung 102 61 206.4 hervor. Die Anschlusselemente dieser bekannten Anschlussvorrichtungen sind durch federnde Kupfer blechstreifen gebildet, welche gegen die als runde Stifte ausgebildeten Kontaktelemente in der Anschlussposition des Zählers tangential anliegen, wobei die Anpresskraft des fedemden Anschlusselements Ober das Stromzählergehäuse auf die Tragplatte übertragen wird. Durch die beim Anschluss des Stromzählers verschobenen Kontaktstifte wird ein federndes Überbrückungselement aus einer Überbrückungsposition durch Verbiegung in eine Offenstellung überführt.

Der vorliegenden Erfindung liegt die Aufgabe zugrunde, eine neue Anschlussvorrichtung der eingangs erwähnten Art zu schaffen, die bei verringertem Platzbedarf eine höhere Kontaktsicherheit ermöglicht.

Die diese Aufgabe lösende Anschlussvorrichtung nach der Erfindung ist dadurch gekennzeichnet, dass der Stromzähler auf der Tragplatte durch Schlitzöffnungen in der Tragplatte geführt ist, in welche an vier Ecken vom Boden des Gehäuses vorstehende, die Tragplatte hintergreifende Haken eingreifen.

Gemäß dieser Erfindungslösung werden die Kontaktelemente, bei denen es sich vorzugsweise um Stifte mit einer länglichen Querschnittsfläche handelt, deren Längsachse sich in der Verschiebungsrichtung des Stromzählers erstreckt, zangenartig auf gegenüberliegenden Seiten ergriffen, wodurch große, der Kontaktsicherheit dienende Klemmkräfte erzeugt werden können. Eine solche Anschlussvorrichtung erfordert quer zur Vorschubrichtung des Zählers nur wenig Bauraum, so dass auf der Tragplatte für herkömmlich mittels Zählerkreuz befestigter Zähler zwei elektronische Zähler und zusätzlich unter der Tragplatte zwischen den Anschlussvorrichtungen Kabelkanäle Platz haben.

In der bevorzugten Ausführungsform der Erfindung sind die Zangenbacken durch die beiden Schenkel einer im wesentlichen U-förmigen Feder gebildet, wobei die U-Schenkel unter Bildung schiefer Ebenen aufgespreizt sind, um das Einschieben des Kontaktelements zu erleichtern. Die Feder kann massiv aus Kupfer hergestellt sein. Zweckmäßig wird jedoch eine Stahlfeder verwendet, wobei auf wenigstens einer Innenbackenseite ein Anschlussleiter aus Kupfer angeordnet ist.

In einer besonders bevorzugten Ausführungsform der Erfindung sind die Anschlusselemente durch ein in Verschiebungsrichtung des Stromzählers verschiebbar geführtes Teil überbrückbar und das Überbrückungsteil beim Anschluss des Stromzählers durch wenigstens eines der Kontaktelemente aus einer Überbrückungsposition in eine Offenstellung verschiebbar. Zweckmäßig ist das Überbrückungsteil durch einen Blechstreifen mit einer Randausnehmung für den Eingriff des Kontaktelements gebildet, wobei die Dicke des Blechstreifens und die Dicke des entsprechend flachen Kontaktelements übereinstimmen. Bei Verschiebungen ist so keine unnötige Öffnungsarbeit zu leisten. Beim Anschluss des Zählers nimmt das Kontaktelement das Überbrückungsteil mit, so dass das Überbrückungsteil an einem Ende aus dem Zangengriff des Anschlusselements gelöst wird.

Um toleranzbedingte Dickenunterschiede auszugleichen, können die Anschlusselemente voneinander unabhängig durch das Überbrückungsteil und das Kontaktelement aufspreizbare Zangenbackenteile aufweisen.

Zweckmäßig ist die Länge des Überbrückungsteils so bemessen, dass die Anschlusselemente in einer Zwischenstellung des Überbrückungsteils sowohl durch das Überbrückungsteil als auch den Stromzähler verbunden sind. Nachteilige Stromunterbrechungen beim Zählerwechsel werden dadurch vermieden.

In weiterer vorteilhafter Ausgestaltung der Erfindung kann das Überbrückungsteil in eine Trennposition mit einem der Netzspannung genügenden Trennabstand verschiebbar sein, wobei das Überbrückungsteil in der Trennposition zweckmäßig arretierbar und die Arretierung mittels eines durch eine der Öffnungen einführbaren Spezialwerkzeugs, welches nur dem betreffenden Energieversorgungsunternehmen zur Verfügung steht, lösbar ist.

In weiterer vorteilhafter Ausgestaltung der Erfindung können Überbrückungsteile für mehrere Stromphasen, insbesondere drei Phasen, untereinander durch isolierende Teile verbunden sein. Somit liegt nur ein einziges Überbrückungselement für alle Phasen vor.

Zweckmäßig sind die Anschlusselemente auf der dem Stromzähler abgewandten Seite an der Tragplatte angebracht.

Die Tragplatte kann ferner zur Befestigung eines Stromzählers mittels Zählerkreuz in herkömmlicher Weise vorgesehen sein, wobei in der Mitte zwischen z.B. zwei auf der Tragplatte angebrachten Stromzählern der Schlitz für die Anbringung des waagerechten Zählerkreuzes verläuft.

In weiterer vorteilhafter Ausgestaltung der Erfindung ist auf wenigstens einer der Backeninnenseiten ein Anschlussleiter aus Kupfer gebildet, der mit einem massiven, zu einer Anschlussklemme führenden Leiterstück in Verbindung steht, wobei der Anschlussleiter einstückig mit dem Leiterstück und das Leiterstück unmittelbar mit der Anschlussklemme verbunden ist.

Vorteilhaft bilden der Anschlussleiter und das den Anschlussleiter mit der Anschlussklemme verbindende Leiterstück ein einziges, leicht montierbares Teil, was die Fertigung einer solchen Anschlussvorrichtung vereinfacht.

Vorteilhaft weist der Anschlussleiter und das damit einstückig verbundene Leiterstück einen, ggf. durch Biegung vorgeformten, Blechstreifen auf, der sich mit geringem Aufwand ausstanzen und ggf. biegen lässt.

Während es denkbar wäre, einen Steckeransatz oder ein Druckstück für die Verbindung mit der Anschlussklemme an dem Leiterstück durch Schweißen oder Löten anzubringen, ist in einer bevorzugten Ausführungsform der Erfindung ein solcher Steckeransatz oder Druckstück einteilig an das Leiterstück angeformt. Ein Druckstück lässt sich durch Verdrehen oder Einschneiden und Abwinkeln des Blechstreifens bilden. Ein Steckeransatz wird zweckmäßig durch Einschneiden des Blechstreifens auf wenigstens einer Längsseite und Biegen, vorzugsweise Rollen, des durch den Einschnitt teilweise abgetrennten Endstückes des Blechstreifens um die Streifenlängsachse hergestellt. Vorteilhaft ist so für das gesamte Leiterstück einschließlich des Verbindungsmittels zur Leiste nur ein einziger Blechstreifen als Ausgangsteil erforderlich.

Die Ausführungsform mit einem Steckeransatz kommt insbesondere bei einem Adapter für einen Stromzähler in Betracht, welcher über die Steckeransätze an eine Zählersteckklemme auf einer Zählertragplatte, die für einen anderen Zähler vorbereitet ist, angeschlossen werden kann.

Der Anschlussleiter kann einschenklig oder zweischenklig in U-Form mit einem am freien Ende einteilig in das Leiterstück übergehenden U-Schenkel ausgebildet sein.

Zur Federbeaufschlagung kann eine gegen das Kontaktelement anlegbare Feder zum Druck des Kontaktelements gegen den Anschlussleiter vorgesehen sein. Hierbei kann es sich um eine einschenklige Blattfeder oder eine U-förmig gebogene Feder handeln, die mit einem U-Schenkel gegen das Kontaktelement und mit dem anderen U-Schenkel gegen den Anschlussleiter anliegt.

Alternativ kann eine solche U-Feder mit ihren beiden U-Schenkeln die Außenseiten beider Schenkel eines U-förmigen Anschlussleiters beaufschlagen.

Der Anschlussleiter oder/und das Leiterstück können selbstfedemd sein, um entweder die den elektrischen Kontakt haltende Federkraft aufzubringen oder die Federkraft einer Stahlfeder zu unterstützen.

In weiterer Ausgestaltung der Erfindung weist das Leiterstück wenigstens eine dem Leiter stück Flexibilität verleihende Schwachstelle auf, durch die sich Abmessungstoleranzen ausgleichen lassen.

Das Leiterstück kann zwischen Haltestegen einlegbar sein, die an die Form des Leiterstücks angepasst sind.

Die Erfindung soll nun anhand von Ausführungsbeispielen und der beiliegenden, sich auf diese Ausführungsbeispiele beziehenden Zeichnungen näher erläutert werden. Es zeigen:
- Fig. 1: einen mit Hilfe der Vorrichtung nach der Erfindung anschließbaren elektronischen Zähler in einer Ansicht von unten,
- Fig. 2: den Zähler von Fig. 1 in einer Seitenteilansicht,
- Fig. 3: einen Ausschnitt aus einer den Zähler von Fig. 1 aufnehmenden Tragplatte,
- Fig. 4: Anschlusselemente und Überbrückungsteile gemäß einem ersten Ausführungsbeispiel für die Erfindung in einer Draufsicht,
- Fig. 5: eine Detailseitenansicht der Bauteile von Fig. 4,
- Fig. 6: Anschlusselemente und Verbindungsteile entsprechend einem zweiten Ausführungsbeispiel für die vorliegende Erfindung,
- Fig. 7: eine Trennstellung zwischen den in Fig. 6 gezeigten Anschluss- und Verbindungsteilen,
- Fig. 8: einen die Vorrichtung nach der Erfindung verwendenden Zähler- und Verteilerschrank,
- Fig. 9: eine Anschlussvorrichtung für einen Stromzähler nach der Erfindung,
- Fig. 10: Details der Anschlussvorrichtung von Fig. 9,
- Fig. 11: ein weiteres Ausführungsbeispiel für ein in der Vorrichtung von Fig. 9 verwendbares Anschlusselement, und
- Fig. 12: eine Ausführungsform eines in der Vorrichtung von Fig. 9 verwendbaren Leiterstücks.

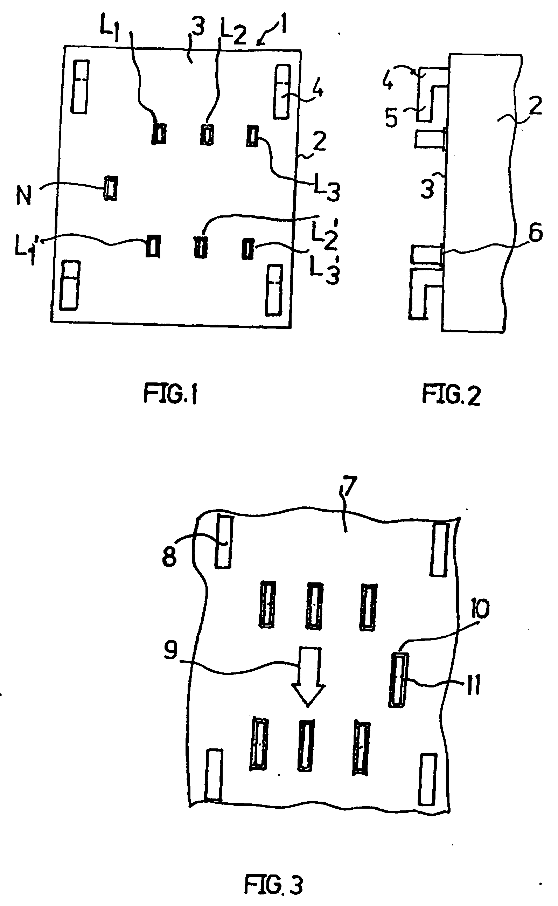

Ein in Fig. 1 und 2 gezeigter elektronischer Stromzähler weist ein isolierendes Gehäuse 2 aus Kunststoff mit einem ebenen Boden 3 auf. Von dem ebenen Boden 3 stehen an vier Ecken an den Boden einstückig angeformte Hakenteile 4 mit einem sich parallel zur Bodenfläche erstreckenden Hakenschenkel 5 vor.

Aus dem Boden 3 des Gehäuses 2 ragen ferner insgesamt sieben Kupferkontaktstifte heraus, von denen der Kontaktstift N zur Verbindung mit dem Neutralleiter vorgesehen ist. Entsprechend drei Stromphasen sind drei Kontaktstiftpaare L1, L1', L2, L2' und L3, L3' vorgesehen. An den Austrittsstellen der Kontaktstifte bildet das Kunststoffmaterial des Gehäusebodens 3 einen vorstehenden Wulst 6.

Eine in Fig. 3 ausschnittsweise gezeigte Tragplatte 7 für den Stromzähler 1 weist vier Schlitzöffnungen 8 auf, in welche die Hakenteile 4 beim Aufsetzen des Stromzählers 1 auf die Platte 7 eintreten. Bei Verschiebung des Stromzählers gemäß Pfeil 9 hintergreifen die Hakenschenkel 5 die Tragplatte 7. Die Schlitzöffnungen 8 bilden eine Führung für den Stromzähler 1.

Entsprechend den vorstehenden Kontaktstiften sind in der Tragplatte insgesamt sieben Öffnungen 10 mit einer Randabstufung 11 gebildet. Der die Randabstufung 11 ausfüllende Wulst 6 erschwert unbefugten Zugang zu den Kontaktelementen. Die in dem betreffenden Ausführungsbeispiel einen Querschnitt in Form eines länglichen Rechtecks aufweisenden Kontaktstifte sind innerhalb der Öffnungen 10 in Richtung des Pfeils 9 verschiebbar.

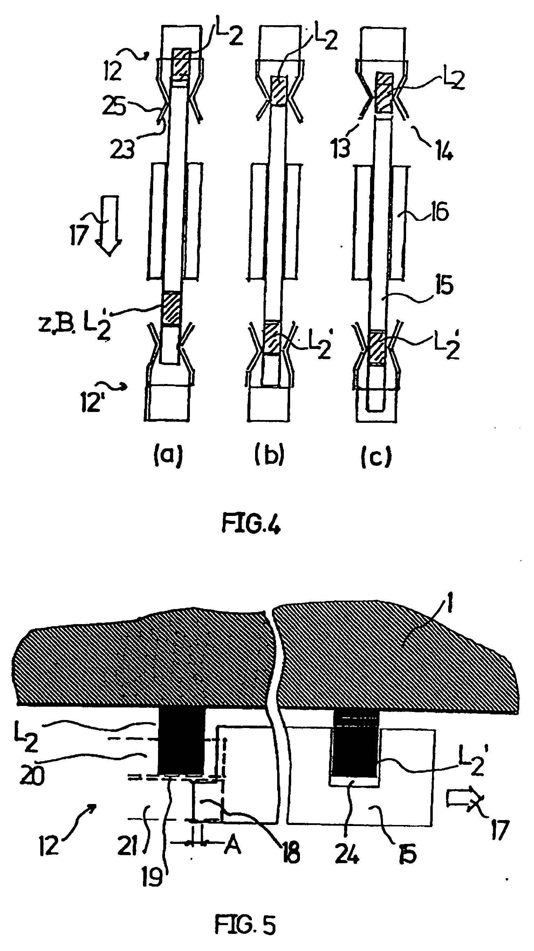

Es wird nun auf die Fig. 4 und 5 Bezug genommen, wo Anschlusselemente 12 und 12' gezeigt sind, welche an der dem Stromzähler 1 abgewandten Seite der Tragplatte 7 an der Tragplatte 7 angebracht sind.

Die eine im wesentlichen U-förmige Feder mit Schenkeln 13 und 14 aufweisenden Anschlusselemente 12 greifen in einem Zustand, in dem der Stromzähler 1 nicht oder gerade auf die Tragplatte 7 aufgesetzt ist, zangenartig an beiden Enden eines durch einen Blechstreifen gebildeten Überbrückungsteils 15 an. Die Blechdicke ist gleich der Dicke der Kontaktstifte. Die drei, jeweils eine Stromphase führenden Überbrückungsteile 15 sind jeweils in einer Führung 16 gemäß Pfeil 17 verschiebbar.

Wie insbesondere aus Fig. 5 hervorgeht, weisen die Überbrückungsteile 15 jeweils eine Randausnehmung 24 auf, in welche beim Aufsetzen des Stromzählers 1 auf die Tragplatte 7 die Kontaktstifte L1' bis L3' eingreifen. Beim Anschließen des Zählers und Verschieben des Zählers in Richtung des Pfeils 9 (Fig. 3) nehmen die betreffenden Kontaktstifte das Überbrückungsteil 15 mit und verschieben es in Richtung des Pfeils 17.

In Fig. 4b ist eine in Fig. 5 näher erläuterte Zwischenstellung gezeigt, in welcher die Kontaktstifte L1 bis L3 bereits in Kontakt mit dem betreffenden Anschlusselement 12 sind, die Überbrückungsteile 15 aber über eine Verlängerung 18 auch noch in Kontakt mit den Anschlusselementen stehen.

Wie Fig. 5 zeigt, existiert ein Überlappungsbereich A, in welchem diese Doppelkontaktierung vorliegt. Wie Fig. 5 ferner erkennen lässt, sind die Federschenkel 13 und 14 durch einen Schlitz 19 in Federschenkelteile 20 und 21 unterteilt, wobei die Kontaktstifte L1 bis L3 nur in Kontakt mit dem Schenkelteil 20 und die Verlängerung 18 nur in Kontakt mit dem Schenkelteil 21 steht. Toleranzbedingte Dickenunterschiede zwischen Kontaktstiften und Blech des Überbrückungsteils 15 können so nicht zur Aufhebung von Kontakten führen.

In Fig. 4c stehen nur noch die vom Boden des Stromzählers 1 vorstehenden Kontaktstifte in Verbindung mit den Anschlusselementen 12. An einem Ende der Überbrückungsteile 15 ist bei 22 eine Luft- und Kriechstrecke zu den betreffenden Anschlusselementen 12 gebildet.

In dem betreffenden Ausführungsbeispiel bestehen die Federn aus einem Innenteil 23 aus Kupfer und einem die Federwirkung verstärkenden Außenteil 25 aus Stahl. Von den Anschlusselementen 12 können mit diesen verbundene Stromkabel wegführen oder sie können Bestandteil eines vorgeformten massiven Leiterteils sein, das z.B. zu einer Anschlussleiste führt.

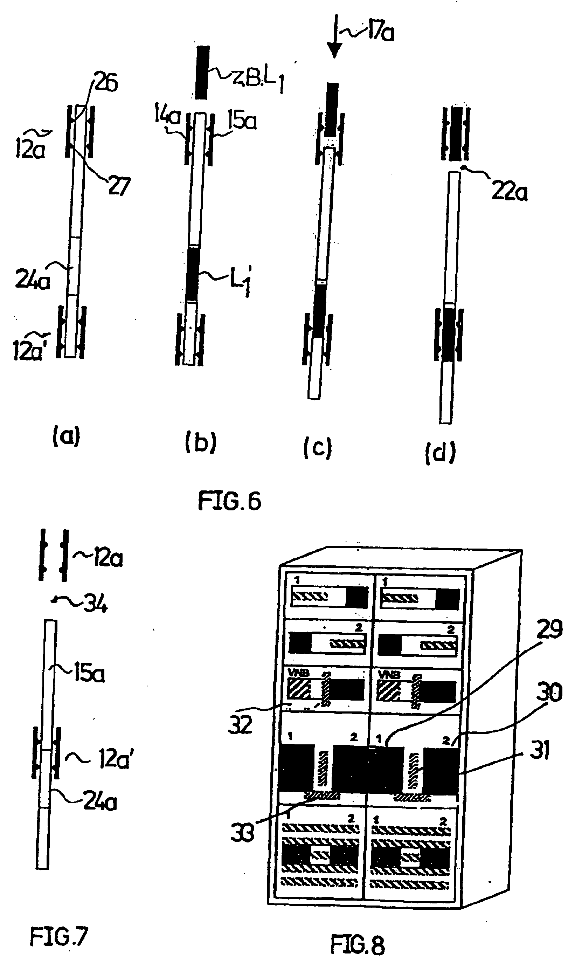

Fig. 6 erläutert nochmals anhand anderer Anschlusselemente die verschiedenen Anschlussphasen. In dem betreffenden Ausführungsbeispiel sind schematisch Anschlusselemente 12a gezeigt, deren Federschenkel (14a,15a) parallel zur Tragplatte 7, wie die Federschenkel 13 und 14 der Anschlusselemente 12 oder senkrecht dazu verlaufen. In diesem Fall sind in Verschiebungsrichtung gemäß Pfeil 17a zwei Kontaktbuckel 26 und 27 vorgesehen. Zwischen den Kontaktbuckeln könnten die Federschenkel 14a und 15a aus obengenanntem Grund geschlitzt sein.

Fig. 6a zeigt die Stellung von Überbrückungsteilen 15a bei Abwesenheit des Stromzählers. In Fig. 6b ist der Stromzähler auf die Tragplatte 1 aufgesetzt, jedoch noch nicht verschoben. Fig. 6c zeigt die Zwischenstellung, in welcher die Überbrückungsteile 15a die Anschlusselemente 12a noch kurzschließen. In Fig. 6d ist der Zähler angeschlossen und zwischen einem Ende der Überbrückungsteile 15a und dem betreffenden Anschlusselement 12a ist eine Luft- und Kriechstrecke 22a gebildet.

In einem in Fig. 7 gezeigten Zustand sind die Überbrückungsteile 15a soweit zurückgezogen, dass bei 34 eine Trennstrecke gebildet ist, deren Länge der anliegenden Netzspannung genügt. In der in Fig. 7 gezeigten Position befinden sich die Überbrückungsteile 15a bei Anlieferung eines die Vorrichtung verwendenden Zähler- und Verteilerschranks. In dieser Position sind die Übertirückungsteile über eine nicht gezeigte Vorrichtung arretierbar, die sich mit einem durch eine der Öffnungen 10 geführten Spezialwerkzeug lösen lässt. Zum Beispiel kann durch das Werkzeug eine die Verbindungsteile in der gezeigten Position haltende Widerhakenformschlusshalterung gelöst werden.

Fig. 8 zeigt einen Zähler- und Verteilerschrank, an welchem Stromzähler in der vorangehend beschriebenen Weise angeschlossen werden können. Die geringe Breite der Anschlussvorrichtung erlaubt eine so geringe Breite der Zählergehäuse, dass auf herkömmlichen Zählerplätzen zwei Zähler 29 und 30 untergebracht werden können. Dazwischen besteht sogar noch Raum für unter der Zählertragplatte angeordnete Kabelkanäle, wie bei 31 angedeutet ist. Oberhalb der in ihren Abmessungen kleinen Zähler 29,30 besteht Raum für ein gesondertes Feld 32, in dem das Energieversorgungsuntemehmen Steuereinrichtungen u. dgl. plazieren kann.

Die Zählertragplatte kann zur Aufnahme herkömmlicher, durch Zählerkreuz anbringbare Zähler vorbereitet sein, wobei zwischen den Zählern ein Schlitz für die Anbringung eines waagerechten Zählerkreuzschenkels und einer Öffnung 33 zur Kabeldurchführung vorzusehen wäre. Ein vertikaler Zählerkreuzschenkel lässt sich innerhalb des Feldes 32 zur Befestigung einer Geräte tragenden Hutschiene oder direkt zur Befestigung von Geräten benutzen.

Die Vorrichtung könnte Bestandteil des Adapters sein, der in der inhaltlich neben der DE 100 52 998 A1 hier einbezogenen deutschen Patentanmeldung 102 61 204.6 beschrieben ist und welcher sich an herkömmlichen Zählerplätzen anbringen lässt, um Stromzähler der beschriebenen Art aufzunehmen. Dieser Adapter könnte oberhalb des Zählers ein durch das Versorgungsunternehmen nutzbares Fach entsprechend dem Feld 32 aufweisen.

Ferner bietet die Erfindungslösung Platz, unter den Zählern zwischen den Haken 4 und Kontaktstiften L3,L3' noch einen weiteren Kabelkanal für den Anschluss von Zusatzeinrichtung oder/und zum Zähler führender Kabel zu bilden.

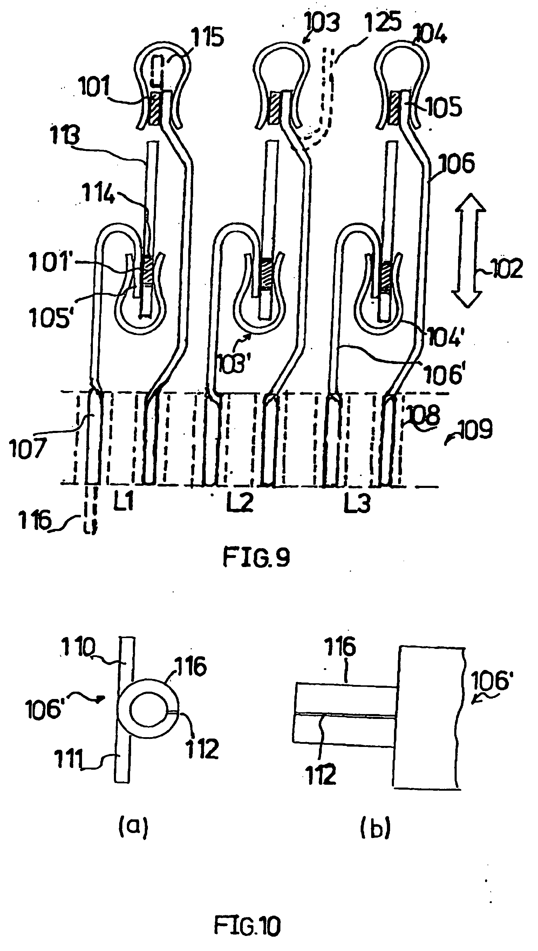

Mit dem Bezugszeichen 101 bzw. 101' sind in Fig. 9 im Querschnitt längliche Kontaktstifte bezeichnet, die von einer Bodenfläche eines Stromzählergehäuses vorstehen und durch Schlitze in einer den Stromzähler aufnehmenden Tragplatte hindurchragen. Der Stromzähler und die Tragplatte sind in Fig. 9 nicht gezeigt. Entsprechend drei Stromphasen L1, L2 und L3 sind drei Paare solcher Kontaktstifte 101,101' vorgesehen.

Der Stromzähler lässt sich auf der Tragplatte in einer Führung verschieben, so dass sich die Kontaktstifte 101,101' gemäß Pfeil 102 hin- und herbewegen können.

Zur Herstellung elektrischer Verbindungen mit den Kontaktstiften 101,101' dienen Anschlusselemente 103 bzw. 103', welche eine in dem betreffenden Ausführungsbeispiel etwa U-förmig gebogene Feder 104 bzw. 104' aus einem Federwerkstoff und einen Anschlussleiter 105 bzw. 105' aus Kupfer zur Sicherung einer ausreichenden Kontaktierung aufweisen.

Der Anschlussleiter 105 bzw. 105' geht einstückig in ein massives Leiterstück 106 bzw. 106' über, wobei Anschlussleiter und Leiterstück aus einem einzigen, gebogenen Blechstreifen gebildet sind.

Die gebogenen Leiterstücke 106,106' weisen jeweils ein flaches Druckstück 107 auf, das in eine Buchse 108 einer Anschlussleiste 109 geführt und durch Verdrehung eines Endabschnitts der Leiterstücke 106,107 gebildet ist. Strichlinien bei 125 deuten an, dass die Leiterstücke 106 auch zu einer oberhalb der Anschlusselemente 103 gelegenen weiteren Anschlussleiste, insbesondere einer Hauptleiteranschlussklemme führen können.

Abweichend von der in Fig. 9 gezeigten Ausführungsform könnten an den Leiterstücken 106,106', wie bei 116 durch Strichlinien angedeutet ist, auch Steckeransätze 116 gebildet sein, die von der Anschlussleiste 109 vorstehen und mit einer weiteren Anschlussleiste verbindbar sind. Letztere Ausführungsform kommt insbesondere dann in Betracht, wenn die gezeigte Vorrichtung Bestandteil eines Adapters für einen Stromzähler ist, und der Adapter mit dem angekoppelten Zähler an eine Zählersteckklemme auf einer für die Aufnahme eines anderen Stromzählers vorgesehenen Tragplatte gekoppelt werden soll. In dem betrachteten Fall werden die Leiterstücke durch die Anschlussleiste 109 hindurchgeführt oder es sind andere Einrichtungen zum Führen und Halten der Leiterstücke vorgesehen.

Wie Fig. 10 erkennen lässt, sind zur Bildung des Steckeransatzes 116 die Leiterstück-blechstreifen unter Erzeugung von Schnittflächen 110 und 111 an ihren Längsrändern eingeschnitten und die durch die einander gegenüberliegenden Einschnitte teilweise abgetrennten Blechendstücke um die Streifenlängsachse gerollt, wobei Randflächen der Blechendstücke bei 112 aneinanderstoßen.

Das Bezugszeichen 113 weist auf Verbindungsstücke hin, welche die Anschlussleiter 105,105' bei Abwesenheit eines Stromzählers elektrisch miteinander verbinden. Die vorzugsweise durch einen Kupferblechstreifen gebildeten Verbindungsstücke 113 weisen jeweils eine Randausnehmung 114 für den Eingriff des betreffenden Kontaktstifts 101' auf, so dass die Verbindungselemente 113 gemäß Pfeil 102 durch Verschiebung des Stromzählers hin- und herbewegbar sind.

Halterungs- und Führungsteile für die Federn 104, die Leiterstücke 106 und die Verbindungsstücke 113 sind in Fig. 9 nicht gezeigt. Solche Teile können z.B. einstückig mit der obengenannten Tragplatte verbunden sein.

Beim Aufsetzen eines Zählers auf die genannte Tragplatte greifen die Kontaktstifte 101' in die Randausnehmungen 114 ein, während die Kontaktstifte 101 in die bei 115 angedeutete Stellung innerhalb der Feder 104 gelangen. Mit der Verschiebung des Stromzählers auf der Tragplatte in eine Anschlussposition verschieben sich die Kontaktstifte 101,101' in die in Fig. 9 gezeigten Stellungen, in welchen die Überbrückung durch die Verbindungsstücke 113 aufgehoben ist und die Stiftpaare 101,101' in elektrischer Verbindung mit den Anschlusselementen 104,104' stehen. In einer Zwischenstellung sind sowohl die Kontaktstifte 101 und 101' als auch beide Enden der Verbindungsstücke 113 mit dem betreffenden Anschlussleiter 105 bzw. 105' verbunden.

In den nachfolgenden Figuren sind gleiche oder gleichwirkende Teile mit derselben Bezugszahl wie in Fig. 9 und 10 bezeichnet, wobei den betreffenden Bezugszahlen jeweils der Buchstabe a oder c beigefügt ist.

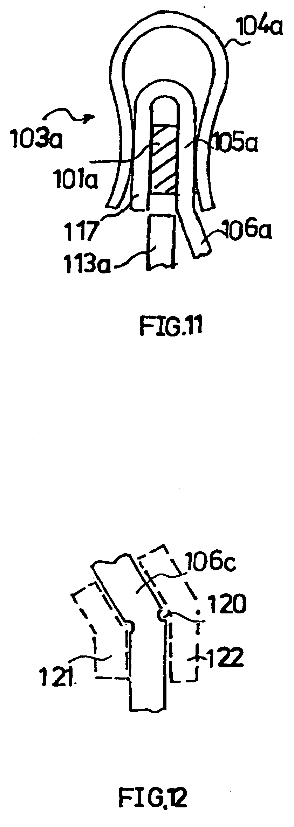

Das Ausführungsbeispiel gemäß Fig. 11 für ein Anschlusselement 103a unterscheidet sich von den vorangehend gezeigten Anschlusselementen 103 dadurch, dass ein einstückig mit einem Leiterstück 106a verbundener Anschlussleiter 105a U-förmig mit einem weiteren Schenkel 117 ausgebildet ist, so dass ein Kontaktstift 101a beidseitig gegen den Anschlussleiter anliegt. Eine U-förmige Feder 104a liegt mit ihren beiden Schenkeln gegen die Außenseiten der Schenkel des U-förmigen Anschlussleiters 105a an.

Ein in Fig. 12 ausschnittsweise dargestelltes Leiterstück 106c weist an einer Biegungsstelle einander gegenüberliegende Einkerbungen 120 auf, die für eine solche Flexibilität des Leiterstücks sorgen, dass Toleranzabweichungen des Leiterstücks und ggf. des das Leiterstück haltender, z.B. mit der Trägerplatte verbundener Haltestege 121 und 122 ausgeglichen werden können.

## Patentansprüche

1. Anordnung aus einem Stromzähler (1) und einer Anschlussvorrichtung für den Stromzähler (1), der ein Gehäuse (2) aufweist, von dessen gegen eine Tragplatte (7) der Anschlussvorrichtung anlegbarem Boden (3) durch Öffnungen (10) in der Tragplatte (7) hindurchführbare Kontaktelemente (L1-L3) entsprechend wenigstens einer Stromphase vorstehen, welche durch Verschiebung des auf der Tragplatte (7) geführten Gehäuses mit Strom zu- und abführenden Anschlusselementen (12,12') auf der dem Stromzähler (1) abgewandten Seite der Tragplatte verbindbar sind, wobei die Anschlusselemente (12) an den Kontaktelementen (L1-L3) zangenartig mit durch die Verschiebebewegung der Kontaktelemente (L1-L3) aufspreizbaren, federkraftbeaufschlagten Zangenbacken (13, 14) angreifen,
**dadurch gekennzeichnet,**
**dass** der Stromzähler (1) auf der Tragplatte (7) durch Schlitzöffnungen (8) in der Tragplatte (7) geführt ist und an vier Ecken vom Boden (3) des Gehäuses (2) vorstehende Haken (4) umfasst, welche in die Schlitzöffnungen (8) eingreifen und bei der Verschiebung des Stromzählers (1) die Tragplatte (7) hintergreifen.

2. Anordnung nach Anspruch 1,
**dadurch gekennzeichnet,**
**dass** die Anschlusselemente (12,12') durch ein in Verschiebungsrichtung des Stromzählers (1) verschiebbar geführtes Teil (15) überbrückbar und das Überbrückungsteil (15) beim Anschluss des Stromzahlers (1) durch wenigstens eines der Kontaktelemente (L1-L3') aus einer Überbrückungsposition in eine Offenstellung verschiebbar ist.

3. Anordnung nach Anspruch 2,
**dadurch gekennzeichnet,**
**dass** die Anschlusselemente (12,12') in einer Zwischenstellung des Überbrückungsteils (15) sowohl durch das Überbrückungsteil (15) als auch den Stromzähler (1) verbunden sind.

4. Anordnung nach einem der Ansprüche 1 bis 3,
**dadurch gekennzeichnet,**
**dass** die Anschlusselemente (12) voneinander unabhängig durch das Überbrückungsteil (15) und das Kontaktelement (L1'-L3') aufspreizbare Zangenbackenteile (20,21) aufweisen.

5. Anordnung nach einem der Ansprüche 1 bis 4,
**dadurch gekennzeichnet,**
**dass** Überbrückungsteile für mehrere Stromphasen untereinander durch isolierende Teile verbunden sind.

6. Anordnung nach einem der Ansprüche 1 bis 5,
**dadurch gekennzeichnet,**
**dass** die Kontaktelemente Kontaktstifte mit einer länglichen Querschnittsfläche sind, deren Längsachse sich in der Vorschubrichtung des Stromzählers (1) erstreckt.

7. Anordnung nach einem der Ansprüche 2 bis 6,
**dadurch gekennzeichnet,**
**dass** das Überbrückungsteil (15a) in eine Trennposition mit einem der Netzspannung genügenden Trennabstand verschiebbar ist.

8. Anordnung nach einem der Ansprüche 1 bis 7,
**dadurch gekennzeichnet,**
**dass** die Zangenbacken durch die beiden Schenkel (13,14) einer im wesentlichen U-förmigen Feder gebildet sind.

9. Anordnung nach einem der Ansprüche 1 bis 8,
**dadurch gekennzeichnet,**
**dass** auf wenigstens einer der Backeninnenseiten ein Anschlussleiter (23) aus Kupfer gebildet ist.

10. Anordnung nach einem der Ansprüche 1 bis 9,
**dadurch gekennzeichnet,**
**dass** die Anschlusselemente (12) auf der dem Stromzähler (1) abgewandten Seite der Tragplatte (7) an der Tragplatte (7) angebracht sind.

11. Anordnung nach einem der Ansprüche 7 bis 10,
**dadurch gekennzeichnet,**
**dass** das Überbrückungsteil (15) in der Trennposition arretierbar und die Arretierung mittels eines durch eine der Öffnungen (9) einführbares Spezialwerkzeug lösbar ist.

12. Anordnung nach einem der Ansprüche 1 bis 11,
**dadurch gekennzeichnet,**
**dass** auf wenigstens einer der Backeninnenseiten ein Anschlussleiter (105,105') aus Kupfer gebildet ist, der mit einem massiven, zu einer Anschlussklemme (109) führenden Leiterstück (106,106') in Verbindung steht, und dass der Anschlussleiter (105,105') einstückig mit dem Leiterstück (106,106') und das Leiterstück (106,106') unmittelbar mit der Anschlussklemme (109) verbunden ist.

13. Anordnung nach Anspruch 12,
**dadurch gekennzeichnet,**
**dass** der Anschlussleiter (105,105') und das damit einstückig verbundene Leiterstück (106,106') einen Blechstreifen aufweist, der ggf. durch Biegung vorgeformt ist.

14. Anordnung nach Anspruch 12 oder 13,
**dadurch gekennzeichnet,**
**dass** ein mit dem Leiterstück (106,106') verbundener Steckeransatz (116) für die Verbindung mit der Anschlussklemme (109) durch Einschneiden des Blechstreifens an den Längsrändern und Biegen, vorzugsweise Rollen, der durch die Einschnitte abgetrennten Endstücke des Blechstreifens um die Streifenlangsachse hergestellt ist.

## Claims

1. Arrangement of an electricity meter (1) and a connecting device for the electricity meter (1), which has a housing (2) from whose base (3), placeable against a carrier plate (7) of the connecting device, contact elements (L1-L3) corresponding to at least one current phase protrude, said contact elements (L1-L3) being configured to be fed through openings (10) in the carrier plate (7), wherein said contact elements can be connected to connecting elements (12, 12') supplying and drawing current on the side of the carrier plate facing away from the electricity meter (1) by translation of the housing guided on the carrier plate (7), wherein the connecting elements (12) on the contact elements (L1-L3) grip in forceps fashion, by means of springy jaws (13, 14) which are spreadable by the translation motion of the contact elements (L1-L3)
**characterised in that**
the electricity meter (1) is guided on the carrier plate (7) by means of slotted openings (8) in the carrier plate (7) and comprises hooks (4) protruding at four corners of the base (3) of the housing (2), which hooks engage in the slotted openings (8) and grip behind the carrier plate (7) as the electricity meter (1) is translated.

2. Arrangement according to claim 1,
**characterised in that**,
the connecting elements (12, 12') can be by-passed by a component (15) guided so that it is able to translate in the translation direction of the electricity meter (1) and the by-passing component (15) can be translated from a by-pass position to an open position when connecting the electricity meter (1) by at least one of the contact elements (L1-L3').

3. Arrangement according to claim 2,
**characterised in that**,
in an intermediate position of the by-passing component (15), the connecting elements (12, 12') are connected both by the by-passing component (15) as well as by the electricity meter (1).

4. Arrangement according to one of the claims 1 to 3,
**characterised in that**,
the connecting elements (12) have jaw elements (20, 21) spreadable independently of each other by the by-passing component (15) and the contact element (L1'-L3').

5. Arrangement according to one of the claims 1 to 4,
**characterised in that**,
the by-passing components for multiple current phases are connected to each other by insulating parts.

6. Arrangement according to one of the claims 1 to 5,
**characterised in that**,
the contact elements are contact pins with a lengthwise cross section whose longitudinal axis extends in the direction of advance of the electricity meter (1).

7. Arrangement according to one of the claims 2 to 6,
**characterised in that**,
the by-passing component (15a) is translatable into a disconnecting position with a disconnection gap adequate for the mains voltage.

8. Arrangement according to one of the claims 1 to 7,
**characterised in that**,
the jaws are formed by the two legs (13, 14) of an essentially U-shaped spring.

9. Arrangement according to one of the claims 1 to 8,
**characterised in that**,
at least one of the inner sides of the jaws is a conductor (23) made from copper.

10. Arrangement according to one of the claims 1 to 9,
**characterised in that**,
the connecting elements (12) are attached to the carrier plate (7) on the side of the carrier plate (7) facing away from the electricity meter (1).

11. Arrangement according to one of the claims 7 to 10,
**characterised in that**,
the by-passing component (15) can be locked in the disconnecting position and the locking can be unlocked by means of a special tool which can be inserted through one of the openings (9).

12. Arrangement according to one of the claims 1 to 11,
**characterised in that**,
a terminal conductor (105, 105') is formed from copper on at least one of the inner sides of the jaws, said terminal conductor being connected to a solid conducting component (106, 106') leading to a connection terminal (109), and that the terminal conductor (105, 105') is connected in one piece with the conducting component (106, 106') and the conducting component (106, 106') is connected directly to the connection terminal (109).

13. Arrangement according to claim 12,
**characterised in that**,
the terminal conductor (105, 105') and the conducting component (106, 106') connected to it in one piece have a metal strip which is formed, possibly by bending.

14. Arrangement according to claim 12 or 13,
**characterised in that**,
a plug pin (116) connected to the conducting component (106, 106') and for connecting to the connection terminal (109) is produced by an incision of the metal strip at the longitudinal edges and bending, preferably rolling, the end sections of the metal strip parted by the incision about the longitudinal axis of the strip.

## Revendications

1. Système constitué d'un compteur d'électricité (1) et d'un dispositif de connexion pour le compteur d'électricité (1), lequel compteur présente un boîtier (2) du fond (3) duquel - fond qui peut être appliqué contre une plaque de support (7) du dispositif de connexion- des éléments de contact (L1-L3), qui peuvent être passés à travers des ouvertures (10) dans la plaque de support (7), dépassent conformément à au moins une phase de courant, éléments qui, par translation du boîtier guidé sur la plaque de support (7), peuvent être reliés à des éléments de connexion (12, 12') d'entrée et de sortie de courant sur le côté de la plaque de support (7) opposé au compteur d'électricité (1), sachant que les éléments de connexion (12) agissent sur les éléments de contact (L1-L3) à la manière de pinces par des becs de pince (13, 14) sollicités par force de ressort, pouvant être écartés par le mouvement de translation des éléments de contact (L1-L3), **caractérisé en ce que** le compteur d'électricité (1) est guidé sur la plaque de support (7) par des ouvertures en forme de fentes (8) dans la plaque de support (7) et comprend, aux quatre coins du fond (3) du boîtier (2), des crochets (4) en saillie qui s'engagent dans les ouvertures en forme de fentes (8) et qui s'engagent derrière la plaque de support (7) lors de la translation du compteur d'électricité (1).

2. Système selon la revendication 1, **caractérisé en ce que** les éléments de connexion (12, 12') peuvent être pontés par une pièce (15) guidée en translation dans la direction de translation du compteur d'électricité (1), et la pièce de pontage (15) peut, lors de la connexion du compteur d'électricité (1), être déplacée d'une position de pontage dans une position ouverte par au moins un des éléments de contact (L1-L3').

3. Système selon la revendication 2, **caractérisé en ce que** les éléments de connexion (12, 12') sont, dans une position intermédiaire de la pièce de pontage (15), reliés à la fois par la pièce de pontage (15) et par le compteur d'électricité (1).

4. Système selon l'une des revendications 1 à 3, **caractérisé en ce que** les éléments de connexion (12) présentent des parties de bec de pince (20, 21) pouvant être écartées indépendamment l'une de l'autre par la pièce de pontage (15) et l'élément de contact (L1'-L3').

5. Système selon l'une des revendications 1 à 4, **caractérisé en ce que** des pièces de pontage pour plusieurs phases de courant sont reliées entre elles par des pièces isolantes.

6. Système selon l'une des revendications 1 à 5, **caractérisé en ce que** les éléments de contact sont des broches de contact de section oblongue, dont l'axe longitudinal s'étend dans la direction d'avancement du compteur d'électricité (1).

7. Système selon l'une des revendications 2 à 6, **caractérisé en ce que** la pièce de pontage (15a) peut être déplacée dans une position de coupure avec une distance de coupure suffisante pour la tension du secteur.

8. Système selon l'une des revendications 1 à 7, **caractérisé en ce que** les becs de pince sont formés par les deux branches (13, 14) d'un ressort essentiellement en forme de U.

9. Système selon l'une des revendications 1 à 8, **caractérisé en ce qu'**un conducteur de connexion (23) en cuivre est formé sur au moins l'un des côtés intérieurs de bec.

10. Système selon l'une des revendications 1 à 9, **caractérisé en ce que** les éléments de connexion (12) sont installés sur la plaque de support (7) sur le côté de la plaque de support (7) opposé au compteur d'électricité (1).

11. Système selon l'une des revendications 7 à 10, **caractérisé en ce que** la pièce de pontage (15) peut être bloquée dans la position de coupure, et le blocage peut être supprimé au moyen d'un outil spécial pouvant être introduit par une des ouvertures (9).

12. Système selon l'une des revendications 1 à 11, **caractérisé en ce qu'**un conducteur de connexion (105, 105') en cuivre est formé sur au moins l'un des côtés intérieurs de bec, conducteur qui se trouve en liaison avec une pièce conductrice massive (106, 106') menant à une borne de connexion (109), et **en ce que** le conducteur de connexion (105, 105') est relié d'un seul tenant à la pièce conductrice (106, 106'), et la pièce conductrice (106, 106') est directement reliée à la borne de connexion (109).

13. Système selon la revendication 12, **caractérisé en ce que** le conducteur de connexion (105, 105') et la pièce conductrice (106, 106') qui lui est reliée d'un seul tenant présentent une bande de tôle qui est éventuellement préformée par cintrage.

14. Système selon la revendication 12 ou 13, **caractérisé en ce qu'**un embout de connecteur (116), relié à la pièce conductrice (106, 106') et destiné à la liaison avec la borne de connexion (109), est fabriqué en entaillant la bande de tôle sur les bords longitudinaux et en cintrant, de préférence en roulant, autour de l'axe longitudinal de la bande, les parties terminales de la bande de tôle séparées par les entailles.
